# EUROPEAN PATENT SPECIFICATION

(11) **EP 2 955 862 B1**
(45) Date of publication and mention of the grant of the patent: **25.12.2019**
(21) Application number: 13874802.5
(22) Date of filing: 26.04.2013
(51) Int. Cl.: H04B 1/04, H03F 1/32, H03F 3/24, H04B 1/10, H04L 5/14

(54) **INTERMODULATION CANCELLATION APPARATUS FOR PASSIVE COMPONENT**
INTERMODULATIONSUNTERDRÜCKUNGSVORRICHTUNG FÜR EINE PASSIVE KOMPONENTE
APPAREIL D'ANNULATION D'INTERMODULATION POUR UN COMPOSANT PASSIF

(30) Priority: 07.02.2013 CN 201310048951
(43) Date of publication of application: 16.12.2015
(73) Proprietor: Wuhan Fingu Electronic Technology Co., Ltd., Wuhan, Hubei 430205 (CN)
(72) Inventor: MENG, Qingnan, Wuhan Hubei 430205 (CN)
(74) Representative: Zinnecker, Armin
(86) International application number: PCT/CN2013/074762
(87) International publication number: WO 2014/121560

(56) References cited:
- WO-A1-2010/141860
- WO-A2-03/081795
- CN-A- 1 430 425
- CN-A- 1 512 688
- US-A1- 2003 232 600
- US-A1- 2011 068 865

## Description

### FIELD OF THE INVENTION

The invention relates to the communication field, and more particularly to an intermodulation cancellation device for a passive device.

### BACKGROUND OF THE INVENTION

Passive components such as transmit filter, duplexer, combiner, power-divider and the like are widely used in antenna feed system, which is usually applied to combine receiving pathway and transmitting pathway, and then share one antenna. In an antenna feed system, the signal power of transmitting pathway is far bigger than the signal power of receiving pathway, and transmitted signal can produce a high level of intermodulation signal when passing a passive nonlinear component. At the antenna end, the intermodulation signal falls into the receiving pathway and produces intermodulation interference, causing the antenna feed system to fail. Therefore, when passive components are in operation, the level of passive intermodulation signal produced by the transmitting pathway is required to be as low as possible, in case the intermodulation signal falls into the receiving pathway and causes interference to the receiving pathway.

CN 100 490 307 C discloses an invention comprising a signal processing circuit, a base station and a method to eliminate an intermodulation product. The device according to this publication divides the primary carrier of an input nonlinear unit into two, and an input into two branches respectively. The first branch of the primary carrier when passing the nonlinear unit generates a process signal containing a first group of an intermodulation product, and the second branch of the primary carrier when passing the splitter, the frequency multiplier, the mixer and the regulating circuit generates a control signal containing a second group of a high order intermodulation product. Then the two branches of signal are superimposed. As the second group of the high order intermodulation product and the first group of the intermodulation product have the same frequency, nearly the same amplitude, and opposite phases, the intermodulation signal is cancelled.

This technical solution has the following disadvantages: 1. The technical solution is not applicable to passive components in that the technical solution leaves out of consideration of the different intermodulation value at different position inside the nonlinear unit while the difference is very obvious for passive components. In the passive circuit, the amplitude of transmitted signal decreases a lot and the phase of transmitted signal changes a lot. As a plurality of positions achieve intermodulation, the intermodulation signal generated at the front end of the circuit decreases a lot in the signal transmission process, and the intermodulation signal outputs from the circuit only contains the intermodulation signal generated at the terminal of the circuit. Therefore, as for duplexer, if signal is obtained at the front end of the nonlinear unit, it is impossible for the generated intermodulation cancellation signal to cancel the intermodulation signal at the antenna end. 2. The intermodulation cancellation signal generated by the technical solution is the second group of high order intermodulation product, and is limited to be a fixed order of intermodulation product, and can only be used to cancel the intermodulation signal of nonlinear unit inside the corresponding frequency band, which is a certain limitation.

In addition, other current methods used to decrease the level of passive intermodulation signal mainly focus on the structure and crafts. Extra costs are needed for those methods, the qualification rates of which are hard to control and the repair rate is high.

US 2011/068865 A1 discloses a wireless communication system including a multiplexer distribution network.

WO 03/081795 A2 discloses a passive intermodulation interference control circuit that can be tuned to have a desired frequency response.

### SUMMARY OF THE INVENTION

In view of the above-described problems, it is one objective of the invention to provide an intermodulation cancellation device that has simple structure and convenient operation and is able to cancel the intermodulation signal of the passive device within the whole working frequency band.

To achieve the above objective, in accordance with one embodiment of the invention, there is provided an intermodulation cancellation device for a passive device, comprising the features of claim 1, i.e. comprising: a power coupler, a regulating module, and a nonlinear device having an grounded end. The intermodulation cancellation device comprises an input/output port configured as a common port of input and output, and the input/output port is disposed at one port of the power coupler. In use: The power coupler is configured to couple a part of a transmitted signal comprising a power signal and an intermodulation signal from a passive device through the input/output port, and a level of a coupled transmitted signal is much lower than that of the transmitted signal. The regulating module is configured to perform a first processing of the coupled transmitted signal to produce a first power signal, and the nonlinear device is configured to process the first power signal to produce a first intermodulation cancellation signal and the first power signal after the first processing. The intermodulation cancellation device is configured to reflect the first power signal after the first processing and the first intermodulation cancellation signal at the grounded end of the nonlinear device and to pass the reflected signals through the nonlinear device and the regulation module. The regulating module is configured to perform a second processing of the reflected signals to produce a second power signal converted from the first power signal and a second intermodulation cancellation signal converted from the first intermodulation cancellation signal, wherein the second intermodulation cancellation signal and the intermodulation signal of the transmitted signal of the passive device have a same frequency and level and opposite phases. The intermodulation cancellation device is configured to pass the second power signal and the second intermodulation cancellation signal through the power couple to be superimposed on the intermodulation signal and the power signal of the transmitted signal. The power signal of the transmitted signal is converted into a third power signal being output to the passive device.

The regulating module comprises a phase regulator and a power attenuator. The phase regulator is configured to regulate phases of the coupled transmitted signal and the first intermodulation cancellation signal produced by the nonlinear device. The power attenuator is configured to regulate levels of the coupled transmitted signal and the first intermodulation cancellation signal produced by the nonlinear device.

The intermodulation cancellation device is formed by series electric connection of the power coupler, the phase regulator, the power attenuator and the nonlinear device connected in series. One end of the intermodulation cancellation device is grounded, thereby reflecting the coupled transmitted signal after the first processing at the end of the intermodulation cancellation device.

Preferably, the intermodulation cancellation device is disposed at an antenna port of the passive device, and the power coupler is configured to couple the transmitted signal at the antenna port of the passive device. The power signal coupled by the antenna port and the excitation signal of the intermodulation signal produced by the passive device has the same frequency so that the intermodulation cancellation signal produced by the intermodulation cancellation device has the same frequency as that of the intermodulation signal of the passive device, thereby ensuring successful cancellation.

Preferably, a plurality of the intermodulation cancellation devices is disposed at the antenna port of the passive device for reaching a superimposition effect on the intermodulation signal of the transmitted signal. Multiple intermodulation cancellation signals are produced by the multiple (two or more) intermodulation cancellation devices, and the intermodulation cancellation signals are superimposed to reach a better cancellation effect of the intermodulation signal.

Preferably, the power coupler is configured to couple the power signal within a transmitting frequency band of the passive device.

Preferably, a coupling amount of the power coupler is between 16 and 60 dB, thereby not effecting the transportation of the main signal.

Preferably, the nonlinear device is configured that if an input power is between 0.01 and 100 mW without a DC bias, then an intermodulation signal produced by the nonlinear device is higher than a signal to be cancelled by between 0.01 and 100 pW. Thus, only a small amount of the transmitted/received signal is required to produce the intermodulation cancellation signal.

It is another objective of the invention to provide a duplexer comprising the above intermodulation cancellation device that is able to cancel the passive intermodulation signal of the transmitting pathway at the antenna port of the duplexer.

To achieve the above objective, in accordance with one embodiment of the invention, there is provided a duplexer comprising the intermodulation cancellation device as defined in claim 1.

The regulating module comprises a phase regulator and a power attenuator. The phase regulator is configured to regulate phases of the coupled transmitted signal and the first intermodulation cancellation signal produced by the nonlinear device. The power attenuator is configured to regulate levels of the coupled transmitted signal and the first intermodulation cancellation signal produced by the nonlinear device.

The intermodulation cancellation device is formed by series electric connection of the power coupler, the phase regulator, the power attenuator and the nonlinear device connected in series. One end of the intermodulation cancellation device is grounded, thereby reflecting the coupled transmitted signal after the first processing at the end of the intermodulation cancellation device.

Preferably, the intermodulation cancellation device is disposed at the antenna port of the duplexer, and the power coupler is configured to couple the transmitted/received signal at the antenna port of the duplexer.

Preferably, a plurality of the intermodulation cancellation devices is disposed at the antenna port of the duplexer for reaching the superimposition effect on the intermodulation signal of the transmitted signal.

Preferably, the power coupler is configured to couple the power signal within the transmitting frequency band of the duplexer.

Preferably, a coupling amount of the power coupler is between 16 and 60 dB.

Preferably, the nonlinear device is configured that if the input power is between 0.01 and 100 mW without a DC bias, the intermodulation signal produced by the nonlinear device is higher than the signal to be cancelled by between 0.01 and 100 pW.

It is still another objective of the invention to provide a method for cancelling an intermodulation signal of a passive device. The method is able to cancel the intermodulation signal of the passive device within the working efficiency band and free from the limitation by the fixed order, and to ensure the normal operations of not only the passive device but also the receiving pathway and the transmitting pathway of the antenna feed system.

To achieve the above objective, in accordance with one embodiment of the invention, there is provided a method for cancelling an intermodulation signal of a passive device comprising the features of claim 15.

Preferably, the intermodulation cancellation device is configured to couple the transmitted/received signal is coupled within a transmitting frequency band of the passive device.

Preferably, a coupling amount of the transmitted/received signal coupled by the power coupler is between 16 and 60 dB.

Preferably, the regulating module comprises a phase regulator and a power attenuator; the phase regulator is configured to regulate phases of the coupled transmitted signal and the first intermodulation cancellation signal produced by the nonlinear device; and the power attenuator is configured to regulate levels of the coupled transmitted signal and the first intermodulation cancellation signal produced by the nonlinear device.

The principle of the production of the intermodulation cancellation signal is as follows: when two signals of different frequencies pass through the passive device, a new frequency signal is produced, and the newly formed frequency signal is the product of the intermodulation. The frequency of the intermodulation product is only related to the frequencies of the two input signals rather than the nonlinearity of the device. Thus, as long as the frequency of the input signal keeps constant, the frequency of the intermodulation product keeps that same. The amplitude of the intermodulation product is mainly affected by the amplitude of the input signal and the nonlinearity of the nonlinear device, the amplitude of the input signal is in positive relation with the amplitude of the intermodulation product, and the nonlinearity of the nonlinear device is in positive relation with the amplitude of the intermodulation production.

When two radio-frequency signals have equivalent frequencies and amplitude and exist 180 degree of the phase difference therebetween, the two radio-frequency signals can be interactively cancelled.

In the above described passive device, the transmitted signal produces the transmitted signal comprising the intermodulation signal when passing through the passive device, and the transmitted signal comprising the intermodulation signal is then input into the intermodulation cancellation device, the amplitude of the input signal is in positive relation with the amplitude of the invention. A very small part of the transmitted signal is coupled by the intermodulation cancellation device, and to avoid the influence on the transportation of the original transmitted signal of the passive device, the coupling amount is between 16 and 60 dB, that is, the power of the coupled transmitted signal is smaller than 2.5% of that of the original transmitted signal, and the specific power value varies along with change of the power of the original power signal. After the phase regulation and the power attenuation, this part of the transmitted drives a nonlinear device having strong linearity to produce the power signal comprising the intermodulation cancellation signal. the power signal is reflected at the end of the circuit of the device and passes through the nonlinear device, the phase regulator, and the power attenuator again, the level of the produced power signal is much lower than the level of the transmitted signal of the antenna port, and the intermodulation cancellation signal and the intermodulation signal are equivalent in the frequency and the level and has a phase difference of 180 degree. The produced power signal and the transmitted signal are superimposed by the power coupler at the antenna port of the passive device, and the intermodulation signal and a trace of the transmitted signal are cancelled, so that interference of the intermodulation signal produced by the transmitting pathway on the receiving pathway during the operation of the passive device is reduced. The sequences of the phase regulation and the power attenuation in signal processing are not limited. Degrees of the phase adjustment and the power attenuation are based on the phase and the level of the passive intermodulation signal and are realized by an adjustable means, or setting a fixed value, or a combination of the two means.

The intermodulation cancellation device of the invention overcomes the problems in the prior art. The transmitted signal is coupled at the antenna port, which does not affect the normal operation of the passive device. The produced intermodulation cancellation signal is highly correlated with the intermodulation signal of the duplexer and the intermodulation signal can be cancelled within the whole working frequency band.

The intermodulation cancellation of the invention operates in a passive state, no additional power supplier is required, thereby decreasing the complicity of the circuit, improving the reliability, and reducing the production cost.

The input and output of the intermodulation cancellation device of the invention share one port, the intermodulation cancellation device only occupies a small space when being assembled, thereby not affecting the structural arrangement of the original passive device.

The intermodulation cancellation device is able to decrease the level of the passive intermodulation signal by producing the intermodulation cancellation signal having the same level and a phase of 180 degree different from the intermodulation signal. Due that both the phase and the level of the intermodulation cancellation signal can be regulated by the phase regulator and the power attenuator, the qualified rate of the product are easy to control, the production cost is reduced, which is of great significance to the production.

In addition, the intermodulation cancellation device of the invention is mainly used to intermodulation cancellation of the passive device, compared with the invention disclosed in CN 100 490 307 C, no additional power supply is required, and the production cost is much lower.

### BRIEF DESCRIPTION OF THE DRAWINGS

FIG. **1** is a structure diagram of a duplexer adopting an intermodulation cancellation device;
FIG. **2** is a schematic diagram of a intermodulation cancellation device;
FIG. **3** is a schematic diagram illustrating intermodulation cancellation principle of the intermodulation cancellation device **5**; and
FIG. **4** illustrates variation of an intermodulation value within a working frequency band before and after addition of the intermodulation cancellation device.

### DETAILED DESCRIPTION OF THE EMBODIMENTS

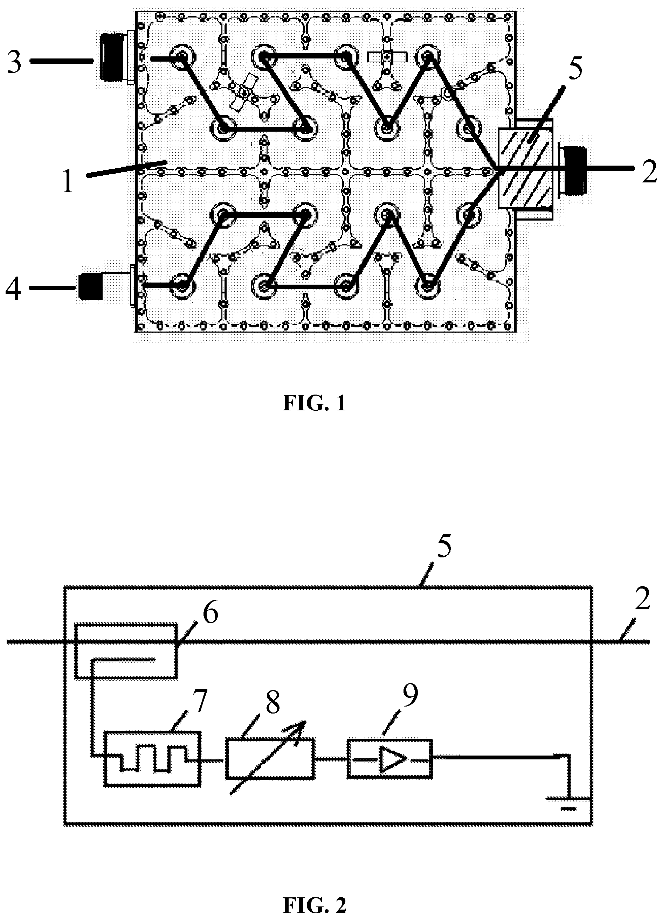

A duplexer **1** provided with an intermodulation cancellation device **5** is shown in in FIG. **1****.** The duplexer **1** comprises an antenna port **2**, a transmitting port **3**, and a receiving port **4.** When the duplexer **1** works, a signal is transmitted from the transmitting port **3** to the duplexer **1** where the transmitted signal is processed and then transmitted out via the antenna port **2.** In the meanwhile, the antenna port **2** can also receive a signal. The received signal enters the duplexer **1** via the antenna port **2** and is then processed and output from the receiving port **4.** Because a signal power of the transmitting path is much higher than that of the receiving pathway, an intermodulation signal caused by the passive nonlinearity falls into the receiving pathway at the antenna port **2**, so that the intermodulation interference occurs which make the antenna feed system fails to work normally. Thus, the passive intermodulation level produced in the transmitting path is required to be as low as possible during the operation of the duplexer **1** in order to prevent the intermodulation signal from falling into the frequency band of the receiving path which otherwise may results in the interference of the receiving pathway. The intermodulation cancellation device **5** is used to cancel the passive intermodulation signal produced by the transmitting pathway.

The intermodulation cancellation device **5** is disposed in the vicinity of the antenna port **2** of the duplexer **1.** An input and an output of the intermodulation cancellation device **5** share one port which is called input/output port. The intermodulation cancellation device **5** is connected to the antenna port **2** of the duplexer **1** via the input/output port. An input signal of the intermodulation cancellation device **5** is the transmitted signal of the antenna port **2**, that is the transmitted signal comprising the intermodulation signal; and an output signal of the intermodulation cancellation device **5** is a transmitted signal comprising an intermodulation cancellation signal. The output signal of the intermodulation cancellation device **5** is output to the antenna port **2** of the passive device **1** via the input/output port for continuing the subsequent processing described in the above.

The intermodulation device **5** is disposed at the antenna port **2** of the duplexer **1**, and only a power signal coupled at the antenna port **2** has the same frequency with an excitation signal of the intermodulation signal produced by the duplexer, so that the intermodulation cancellation signal for cancellation will has the similar frequency changes along with the intermodulation signal produced by the duplexer, otherwise the cancellation of the frequency changes fails.

FIG. **2** is a structure diagram of the intermodulation cancellation device **5.** As shown in FIG. **2**, the intermodulation cancellation device **5** comprises a series connection of a power coupler, a phase regulator **7**, a power attenuator **8**, and a nonlinear device **9**, and an end of the nonlinear device **9** is grounded. The power coupler **6** is used to couple the power signal within the transmitting frequency band, and adopts a structure form that has the power coupling effect and comprises, but not limited to, a microstrip, a probe, and a coupling loop. For the purpose of not affecting the transportation of the main signal, a coupling amount of the power coupler is between 16 and 60 dB, that is, the coupled signal power is smaller than 2.5% of the original signal power; and a specific power value varies along with the power of the original signal. The structure form of the phase regulator **7** comprises, but not limited to, a microstrip transmission line, a cable transmission lien, and an external phase shifter. The nonlinear device **9** comprises a component with relatively strong nonlinearity and functions in producing a relatively poor intermodulation signal at a low input power in the absence of DC bias, for example, when the input power is between 0.01 and 100 mW, the intermodulation signal produced by the nonlinear device reaches between 0.01 and 100 pW. The nonlinear device is, but not limited to, a diode, a triode, a ferrite, or the like.

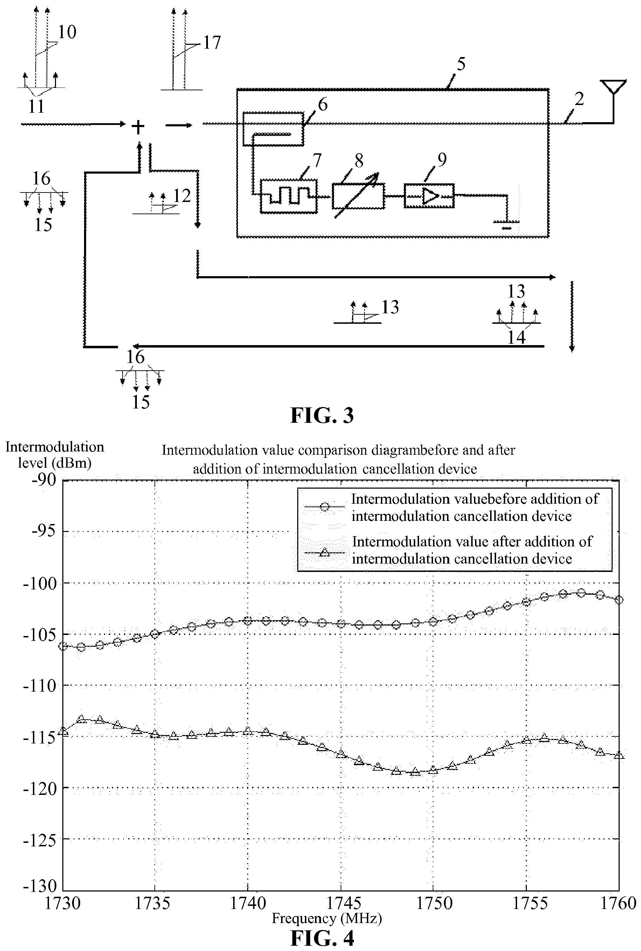

As shown in FIG. **3**, the power signal of the transmitted signal of the passive device is **10**, the intermodulation signal of the transmitted signal produced in the passive nonlinear device is **11.** The transmitted signal comprising the intermodulation signal **11** and the power signal **10** is input into the intermodulation cancellation device **5.** A small part **12** of the power signal is coupled by the power coupler **6.** The power of the power signal **12** is smaller than 2.5% of that of the original power signal **10**, and the specific power value of the power signal **12** varies along with change of power of the original power signal **10.** After being processed by the phase regulator **7** and the power attenuator **8**, the power signal **12** is transformed into a power signal **13.** The power signal **13** is processed by an intermodulation production device **9** and produces the intermodulation cancellation signal **14.** The power signal **13** and the intermodulation cancellation signal **14** are reflected at an grounded end and then pass through the intermodulation production device **9**, the power attenuator **8**, and the phase regulator **7** again, so that the power signal **13** is converted into a power signal **15**, and the intermodulation cancellation signal **14** is converted into an intermodulation cancellation signal **16.** The intermodulation cancellation signal **16** and the intermodulation signal **11** have equivalent frequencies and amplitudes, and a phase difference therebetween is 180 degree; and the power signal **15** and the power signal **10** have equivalent frequencies, and the phase difference therebetween is 180 degree, while the level of the power signal **15** is much lower than the power signal **10.** Finally, the power signal **15** and the intermodulation cancellation signal **16** are respectively superimposed on the intermodulation signal **11** and the power signal **10** when passing through the power coupler **6.** The intermodulation cancellation signal **16** and the intermodulation signal **11** are interactively cancelled, thereby decreasing the power level of the intermodulation signal. The power signal **10** is converted into the power signal **17** after a small part of the power signal **10** is cancelled from by the power signal **15**, because that the level of the power signal **10** is much higher than that of the power signal **15**, the power signal **17** is approximately the same with the power signal **10**, and the influence of the intermodulation cancellation device on the power signal of the transmitted signal is negligible.

The level of the intermodulation signal of the duplexer is cancelled by producing the intermodulation cancellation signal having the same frequency and amplitude with the intermodulation signal and a phase difference between the intermodulation cancellation signal and the intermodulation signal is 180 degree, so that the intermodulation interference of the transmitting pathway on the receiving pathway is reduced. Degrees of the phase adjustment and the power attenuation are based on the phase and the level of the passive intermodulation signal and are realized by an adjustable means, or setting a fixed value, or a combination of the two means. The connection sequences of the phase regulator **7** and the power attenuator **8** are adjustable.

Moreover, only one intermodulation cancellation device **5** is arranged at the antenna port **2** of the duplexer **1.** Optionally, a plurality the intermodulation cancellation device **5** is arranged at the antenna port **2** so as to produce multiple intermodulation cancellation signals which are superimposed to cancel the intermodulation signal of the passive device.

To demonstrate the effect of the intermodulation cancellation device of the invention, intermodulation values of the duplexer before and after addition of the intermodulation cancellation device are measured, and the measurement results are compared in FIG. **4**, from which, it is known that within the working frequency band of between 1730 and 1760 MHz, the intermodulation value is larger than -104 dBm before the addition of the intermodulation cancellation device and is smaller than -113 dBm after the addition of the intermodulation cancellation device. The intermodulation value is reduced by at least 9 dB within the whole working efficiency band. The intermodulation cancellation principle of the invention is proved to be feasible.

The intermodulation cancellation device of the invention is also applicable to the intermodulation cancellation of other passive devices, such as the power divider, the coupler, the electric-wave filter, or the antenna.

In summary, compared with the prior art, the intermodulation cancellation device of the invention is able to regulate the level of the intermodulation signal, make the qualified rate easily controllable, decrease the production cost, and is of great significance for the production.

## Claims

1. An intermodulation cancellation device for a passive device, comprising a power coupler (6), a regulating module (7, 8), and a nonlinear device (9) having a grounded end;
wherein the intermodulation cancellation device (5) comprises an input/output port configured as a common port of input and output, and the input/output port is disposed at one port of the power coupler (6);
wherein the power coupler (6) is configured to couple a part of a transmitted signal (10, 11) comprising a power signal (10) and an intermodulation signal (11) from the passive device through the input/output port, whereby a level of a coupled transmitted signal (12) is lower than the level of the transmitted signal (10, 11);
wherein the regulating module (7, 8) is configured to perform a first processing of the coupled transmitted signal (12) to produce a first power signal (13) and the nonlinear device (9) is configured to process the first power signal (13) to produce a first intermodulation cancellation signal (14) and the first power signal (13) after the first processing;
wherein the intermodulation cancellation device (5) is configured to reflect the first power signal (13) after the first processing and the first intermodulation cancellation signal (14) at the grounded end of the nonlinear device and to pass the reflected signals through the nonlinear device (9) and the regulating module (7, 8), wherein the regulating module (7, 8) is configured to perform a second processing of the reflected signals to produce a second power signal (15) converted from the first power signal (13) and a second intermodulation cancellation signal (16) converted from the first intermodulation cancellation signal (14), wherein the second intermodulation cancellation signal (16) and the intermodulation signal (11) of the transmitted signal of the passive device have a same frequency and level and opposite phases;
wherein the intermodulation cancellation device (5) is configured to pass the second power signal (15) and the second intermodulation cancellation signal (16) through the power coupler (6) to be superimposed on the intermodulation signal (11) and the power signal (10) of the transmitted signal (10, 11) whereby the power signal (10) of the transmitted signal (10, 11) is converted into a third power signal (17) being output to the passive device;
wherein the regulating module comprises a phase regulator (7) and a power attenuator (8); the phase regulator (7) being configured to regulate phases of the coupled transmitted signal (12) and the first intermodulation cancellation signal (14) produced by the nonlinear device (9); and the power attenuator (8) being configured to regulate levels of the coupled transmitted signal (12) and the first intermodulation cancellation signal (14) produced by the nonlinear device; and
wherein the intermodulation cancellation device (5) is formed by series electric connection of the power coupler (6), the phase regulator (7), the power attenuator (8), and the nonlinear device (9) connected in series; and one end of the intermodulation cancellation device is grounded.

2. The device of claim 1, **characterized in that** the intermodulation cancellation device (5) is disposed at an antenna port (2) of the passive device, and power coupler (6) is configured to couple the transmitted signal at the antenna port of the passive device.

3. The device of claim 2, **characterized in that** a plurality of intermodulation cancellation devices (5) is disposed at the antenna port (2) of the passive device for reaching a superimposition effect on the intermodulation signal of the transmitted signal.

4. The device of claim 1, **characterized in that** the power coupler (6) is configured to couple the power signal within a transmitting frequency band of the passive device.

5. The device of claim 1, **characterized in that** a coupling amount of the power coupler is between 16 and 60 dB.

6. The device of claim 1, **characterized in that** the nonlinear device is configured that if an input power is between 0.01 and 100 mW without a DC bias, the intermodulation signal produced by the nonlinear device is higher than a signal to be cancelled by between 0.01 and 100 pW.

7. A duplexer comprising an intermodulation cancellation device, a transmitting port (3), a receiving port (4), and an antenna port (2); the intermodulation cancellation device (5) is disposed at the antenna port (2), **characterized in that** the intermodulation cancellation device (5) comprises the features of any of claims 1 - 6.

8. The duplexer of claim 7, **characterized in that** the intermodulation cancellation device (5) is disposed at the antenna port (2) of the duplexer, and the power coupler (6) is configured to couple the transmitted/received signal at the antenna port of the duplexer.

9. The duplexer of claim 7, **characterized in that** a plurality of the intermodulation cancellation devices (5) is disposed at the antenna port (2) of the duplexer for reaching the superimposition effect on the intermodulation signal of the transmitted signal.

10. The duplexer of claim 7, **characterized in that** the power coupler (6) is configured to couple the power signal within the transmitting frequency band of the duplexer.

11. The duplexer of claim 7, **characterized in that** a coupling amount of the power coupler is between 16 and 60 dB.

12. The duplexer of claim 7, **characterized in that** the nonlinear device is configured that if the input power is between 0.01 and 100 mW without the DC bias, the intermodulation signal produced by the nonlinear device is higher than the signal to be cancelled by between 0.01 and 100 pW.

13. A method for cancelling an intermodulation signal of a passive device, the method comprising the following steps:
1) coupling a part of a transmitted signal (10, 11) comprising a power signal (10) and an intermodulation signal (11) from the passive device through an input/output of an intermodulation cancellation device (5) which is configured as a common port of input and output, wherein a level of a coupled transmitted signal (12) is lower than the level of the transmitted signal (10, 11), wherein the intermodulation cancellation device (5) comprises a power coupler (6), a regulating module (7, 8) and a nonlinear device (9) having a grounded end;
2) performing a first processing of the coupled transmitted signal (12) by the regulating module (7, 8) to enable the coupled transmitted signal to produce a first power signal (13) and processing the first power signal (13) by the nonlinear device to produce a first intermodulation cancellation signal (14) and the first power signal (13);
3) reflecting the first power signal (13) and the first intermodulation cancellation signal (14) at the grounded end of the nonlinear device (9) and passing the reflected signals through the nonlinear device and the regulating module, performing a second processing of the reflected signals by the regulating module (7, 8) to to produce a second power signal (15) converted from the first power signal (13) and a second intermodulation cancellation signal (16) converted from the first intermodulation cancellation signal (14), wherein the second intermodulation cancellation signal (16) and the intermodulation signal (11) of the transmitted signal in the passive device have a same frequency and level and opposite phases;
4) passing the second power signal (15) and the second intermodulation cancellation signal (16) through the power coupler (6) by the intermodulation cancellation device (5) and superimposing the second power signal (15) and the second intermodulation cancellation signal (16) on the intermodulation signal (11) and the power signal (10) of the transmitted signal (10, 11) and output a superimposed signal (17) from the intermodulation cancellation (5) device to the passive device.

14. The method of claim 13, **characterized in that** the intermodulation cancellation device (5) is configured to couple the transmitted/received signal within a transmitting frequency band of the passive device.

15. The method of claim 13, **characterized in that** a coupling amount of the transmitted/received signal coupled by the power coupler (6) is between 16 and 60 dB.

16. The method of claim 13, **characterized in that** the regulating module (7, 8) comprises a phase regulator (7) and a power attenuator (8); the phase regulator (7) is configured to regulate phases of the coupled transmitted signal and the first intermodulation cancellation signal produced by the nonlinear device (9); and the power attenuator (8) is configured to regulate levels of the coupled transmitted signal and the first intermodulation cancellation signal produced by the nonlinear device (9).

## Patentansprüche

1. Intermodulationsunterdrückungsvorrichtung für ein passives Bauteil, aufweisend einen Leistungskoppler (6), ein Reglermodul (7, 8) und eine nichtlineare Vorrichtung (9) mit einem geerdeten Ende;
wobei die Intermodulationsunterdrückungsvorrichtung (5) einen Eingangs/Ausgangsanschluss aufweist, der als gemeinsamer Anschluss eines Eingangs und eines Ausgangs eingerichtet ist, und der Eingangs/Ausgangsanschluss an einem Anschluss des Leistungskopplers (6) angeordnet ist;
wobei der Leistungskoppler (6) eingerichtet ist, einen Teil eines übertragenen Signals (10, 11), das ein Leistungssignal (10) und ein Intermodulationssignal (11) aufweist, von der passiven Vorrichtung durch den Eingangs/Ausgangsanschluss einzukoppeln, wodurch ein Pegel eines eingekoppelten übertragenen Signals (12) niedriger ist als der Pegel des übertragenen Signals (10, 11);
wobei das Reglermodul (7, 8) eingerichtet ist, um eine erste Verarbeitung des eingekoppelten übertragenen Signals (12) durchzuführen, um ein erstes Leistungssignal (13) zu erzeugen, und die nichtlineare Vorrichtung (9) zur Verarbeitung des ersten Leistungssignals (13) eingerichtet ist, um nach der ersten Verarbeitung ein erstes Intermodulationsunterdrückungssignal (14) und das erste Leistungssignal (13) zu erzeugen;
wobei die Intermodulationsunterdrückungsvorrichtung (5) eingerichtet ist, um das erste Leistungssignal (13) nach der ersten Verarbeitung und das erste Intermodulationsunterdrückungssignal (14) an dem geerdeten Ende der nichtlinearen Vorrichtung zu reflektieren, und die reflektierten Signale durch die nichtlineare Vorrichtung (9) und das Reglermodul (7, 8) zu leiten, wobei das Reglermodul (7, 8) eingerichtet ist, um eine zweite Verarbeitung des reflektierten Signals durchzuführen und ein zweites Leistungssignal (15), das aus dem ersten Leistungssignal (13) umgewandelt wurde, und ein zweites Intermodulationsunterdrückungssignal (16), das aus dem ersten Intermodulationsunterdrückungssignal (14) umgewandelt wurde, durchzuführen, wobei das zweite Intermodulationsunterdrückungssignal (16) und das Intermodulationssignal (11) des übertragenen Signals der passiven Vorrichtung eine gleiche Frequenz und Pegel und entgegengesetzte Phasen aufweisen;
wobei die Intermodulationsunterdrückungsvorrichtung (5) eingerichtet ist, das zweite Leistungssignal (15) und das zweite Intermodulationsunterdrückungssignal (16) durch den Leistungskoppler (6) zu leiten, so dass es das Intermodulationssignal (11) und das Leistungssignal (15) des übertragenen Signals (10, 11) überlagert, wodurch das Leistungssignal (10) des übertragenen Signals (10, 11) in ein drittes Leistungssignal (17) umgewandelt wird, das an die passive Vorrichtung ausgegeben wird;
wobei das Reglermodul einen Phasenregler (7) und einen Leistungsdämpfer (8) aufweist; wobei der Phasenregler (7) zum Regeln von Phasen des eingekoppelten übertragenen Signals (12) und des ersten Intermodulationsunterdrückungssignals (14) eingerichtet ist, die von der nichtlinearen Vorrichtung (9) erzeugt werden; und wobei der Leistungsdämpfer (8) eingerichtet ist, Pegel des eingekoppelten übertragenen Signals (12) und des ersten Intermodulationsunterdrückungssignals (14), die von der nichtlinearen Vorrichtung erzeugt werden, zu regeln; und
wobei die Intermodulationsunterdrückungsvorrichtung (5) durch eine elektrische Reihenschaltung des Leistungskopplers (6), des Phasenreglers (7), des Leistungsdämpfers (8) und der nichtlinearen Vorrichtung (8) gebildet wird, die in Reihe geschaltet sind; und ein Ende der Intermodulationsunterdrückungsvorrichtung geerdet ist.

2. Vorrichtung nach Anspruch 1, **dadurch gekennzeichnet, dass** die Intermodulationsunterdrückungsvorrichtung (5) an einem Antennenanschluss (2) der passiven Vorrichtung angeordnet ist, und der Leistungskoppler (6) eingerichtet ist, das übertragene Signal am Antennenanschluss der passiven Vorrichtung einzukoppeln.

3. Vorrichtung nach Anspruch 2, **dadurch gekennzeichnet, dass** eine Vielzahl von Intermodulationsunterdrückungsvorrichtungen (5) an dem Antennenanschluss (2) der passiven Vorrichtung angeordnet ist, um einen Überlagerungseffekt auf dem Intermodulationssignal des übertragenen Signals zu erreichen.

4. Vorrichtung nach Anspruch 1, **dadurch gekennzeichnet, dass** der Leistungskoppler (6) eingerichtet ist, das Leistungssignal innerhalb eines Sendefrequenzbands der passiven Vorrichtung einzukoppeln.

5. Vorrichtung nach Anspruch 1, **dadurch gekennzeichnet, dass** eine Kopplungsmenge des Leistungskopplers zwischen 16 und 60 dB beträgt.

6. Vorrichtung nach Anspruch 1, **dadurch gekennzeichnet, dass** die nichtlineare Vorrichtung eingerichtet ist, dass dann, wenn eine Eingangsleistung zwischen 0,01 und 100 mW ohne eine Gleichstrom-Vorspannung beträgt, das von der nichtlinearen Vorrichtung erzeugte Intermodulationssignal höher als ein zu unterdrückendes Signal zwischen 0,01 und 100 pW ist.

7. Duplexer, aufweisend eine Intermodulationsunterdrückungsvorrichtung, einen Sendeanschluss (3), einen Empfangsanschluss (4) und einen Antennenanschluss (2); wobei die Intermodulationsunterdrückungsvorrichtung (5) an dem Antennenanschluss (2) angeordnet ist, **dadurch gekennzeichnet, dass** die Intermodulationsunterdrückungsvorrichtung (5), die Merkmale nach einem der Ansprüche 1-6 aufweist.

8. Duplexer nach Anspruch 7, **dadurch gekennzeichnet, dass** die Intermodulationsunterdrückungsvorrichtung (5) am Antennenanschluss (2) des Duplexers angeordnet ist, und der Leistungskoppler (6) eingerichtet ist, um das Sende/Empfangssignal am Antennenanschluss des Duplexers einzukoppeln.

9. Duplexer nach Anspruch 7, **dadurch gekennzeichnet, dass** eine Vielzahl der Intermodulationsunterdrückungsvorrichtungen (5) an dem Antennenanschluss (2) des Duplexers angeordnet wird, um den Überlagerungseffekt an dem Intermodulationssignal des übertragenen Signals zu erreichen.

10. Duplexer nach Anspruch 7, **dadurch gekennzeichnet, dass** der Leistungskoppler (6) eingerichtet ist, das Leistungssignal innerhalb des Sendefrequenzbands des Duplexers einzukoppeln.

11. Duplexer nach Anspruch 7, **dadurch gekennzeichnet, dass** eine Kopplungsmenge des Leistungskopplers zwischen 16 und 60 dB beträgt.

12. Duplexer nach Anspruch 7, **dadurch gekennzeichnet, dass** die nichtlineare Vorrichtung eingerichtet ist, dass dann, wenn die Eingangsleistung zwischen 0,01 und 100 mW ohne die Gleichstrom-Vorspannung beträgt, das von der nichtlinearen Vorrichtung erzeugte Intermodulationssignals höher als das unterdrückende Signal zwischen 0,01 und 100 pW ist.

13. Verfahren zum Unterdrücken eines Intermodulationssignals einer passiven Vorrichtung, wobei das Verfahren die folgenden Schritte umfasst:
1) Einkoppeln eines Teils eines übertragenen Signals (10, 11), das ein Leistungssignal (10) und ein Intermodulationssignal (11) aufweist, von der passiven Vorrichtung durch einen Eingang/Ausgang einer Intermodulationsunterdrückungsvorrichtung (5), die als gemeinsamer Anschluss von Eingang und Ausgang eingerichtet ist, wobei ein Pegel eines eingekoppelten übertragenen Signals (12) niedriger ist als der Pegel des übertragenen Signals (10, 11), wobei die Intermodulationsunterdrückungsvorrichtung (5) einen Leistungskoppler (6), ein Reglermodul (7, 8) und eine nichtlineare Vorrichtung (9) mit einem geerdeten Ende aufweist;
2) Durchführen einer ersten Verarbeitung des eingekoppelten übertragenen Signals (12) durch das Reglermodul (7, 8), um es dem eingekoppelten übertragenen Signal zu ermöglichen, ein erstes Leistungssignal (13) zu erzeugen, und Verarbeiten des ersten Leistungssignals (13) durch die nichtlineare Vorrichtung, um ein erstes Intermodulationsunterdrückungssignal (14) und das erste Leistungssignal (13) zu erzeugen;
3) Reflektieren des ersten Leistungssignals (13) und des ersten Intermodulationsunterdrückungssignals (14) am geerdeten Ende der nichtlinearen Vorrichtung (9) und Hindurchleiten des reflektierten Signals durch die nichtlineare Vorrichtung und das Reglermodul, Durchführen einer zweiten Verarbeitung der reflektierten Signale durch das Reglermodul (7, 8), um ein zweites Leistungssignals (15), das aus dem ersten Leistungssignal (13) konvertiert wurde, und ein zweites Intermodulationsunterdrückungssignal (16), das aus dem ersten Intermodulationsunterdrückungssignals (14) konvertiert wurde, zu erzeugen, wobei das zweite Intermodulationsunterdrückungssignal (11) des übertragenen Signals in der passiven Vorrichtung eine gleiche Frequenz und Pegel und entgegengesetzte Phasen aufweist;
4) Hindurchleiten des zweiten Leistungssignals(15) und des zweiten Intermodulationsunterdrückungssignals (16) durch den Leistungskoppler (6) durch die Intermodulationsunterdrückungsvorrichtung (5), und Überlagern des zweiten Leistungssignals (15) und des zweiten Intermodulationsunterdrückungssignals (16) auf das Intermodulationssignal (11) und das Leistungssignal (10) des übertragenen Signals (10, 11) und Ausgeben eines überlagerten Signals (17) aus der Intermodulationsunterdrückungsvorrichtung (5) an die passive Vorrichtung.

14. Verfahren nach Anspruch 13, **dadurch gekennzeichnet, dass** die Intermodulationsunterdrückungsvorrichtung (5) eingerichtet ist, das Sende/Empfangssignal innerhalb eines Sendefrequenzbands der passiven Vorrichtung einzukoppeln.

15. Verfahren nach Anspruch 13, **dadurch gekennzeichnet, dass** eine Kopplungsmenge des vom Leistungskoppler (6) eingekoppelten Sende/Empfangssignals zwischen 16 und 60 dB beträgt.

16. Verfahren nach Anspruch 13, **dadurch gekennzeichnet, dass** das Reglermodul (7, 8) einen Phasenregler (7) und einen Leistungsdämpfer (8) aufweist, wobei der Phasenregler (7) zum Regeln von Phasen des eingekoppelten übertragenen Signals (12) und des ersten Intermodulationsunterdrückungssignals (14) eingerichtet ist, die von der nichtlinearen Vorrichtung (9) erzeugt werden; und der Leistungsdämpfer (8) eingerichtet ist, Pegel des eingekoppelten übertragenen Signals (12) und des ersten Intermodulationsunterdrückungssignals (14), die von der nichtlinearen Vorrichtung (9) erzeugt werden, zu regeln.

## Revendications

1. Dispositif d'annulation d'intermodulation pour un dispositif passif, comprenant un coupleur de puissance (6), un module de régulation (7, 8), et un dispositif non linéaire (9) ayant une extrémité mise à la terre ;
dans lequel le dispositif d'annulation d'intermodulation (5) comprend un port d'entrée/de sortie configuré comme un port d'entrée et de sortie commun, et le port d'entrée/de sortie est disposé au niveau d'un port du coupleur de puissance (6) ;
dans lequel le coupleur de puissance (6) est configuré pour coupler une partie d'un signal transmis (10, 11) comprenant un signal de puissance (10) et un signal d'intermodulation (11) à partir du dispositif passif à travers le port d'entrée/de sortie, moyennant quoi un niveau d'un signal transmis couplé (12) est inférieur au niveau du signal transmis (10, 11) ;
dans lequel le module de régulation (7, 8) est configuré pour réaliser un premier traitement du signal transmis couplé (12) pour produire un premier signal de puissance (13) et le dispositif non linéaire (9) est configuré pour traiter le premier signal de puissance (13) pour produire un premier signal d'annulation d'intermodulation (14) et le premier signal de puissance (13) après le premier traitement ;
dans lequel le dispositif d'annulation d'intermodulation (5) est configuré pour réfléchir le premier signal de puissance (13) après le premier traitement et le premier signal d'annulation d'intermodulation (14) au niveau de l'extrémité mise à la terre du dispositif non linéaire et pour faire passer les signaux réfléchis à travers le dispositif non linéaire (9) et le module de régulation (7, 8), dans lequel le module de régulation (7, 8) est configuré pour réaliser un second traitement des signaux réfléchis pour produire un deuxième signal de puissance (15) converti à partir du premier signal de puissance (13) et un second signal d'annulation d'intermodulation (16) converti à partir du premier signal d'annulation d'intermodulation (14), dans lequel le second signal d'annulation d'intermodulation (16) et le signal d'intermodulation (11) du signal transmis du dispositif passif ont une même fréquence et un même niveau et des phases opposées ;
dans lequel le dispositif d'annulation d'intermodulation (5) est configuré pour faire passer le deuxième signal de puissance (15) et le second signal d'annulation d'intermodulation (16) à travers le coupleur de puissance (6) pour leur superposition sur le signal d'intermodulation (11) et le signal de puissance (10) du signal transmis (10, 11) moyennant quoi le signal de puissance (10) du signal transmis (10, 11) est converti en un troisième signal de puissance (17) qui est délivré au dispositif passif ;
dans lequel le module de régulation comprend un régulateur de phases (7) et un atténuateur de puissance (8) ; le régulateur de phases (7) étant configuré pour réguler des phases du signal transmis couplé (12) et du premier signal d'annulation d'intermodulation (14) produit par le dispositif non linéaire (9) ; et l'atténuateur de puissance (8) étant configuré pour réguler des niveaux du signal transmis couplé (12) et du premier signal d'annulation d'intermodulation (14) produit par le dispositif non linéaire ; et
dans lequel le dispositif d'annulation d'intermodulation (5) est formé par une connexion électrique en série du coupleur de puissance (6), du régulateur de phases (7), de l'atténuateur de puissance (8) et du dispositif non linéaire (9) connectés en série ; et une extrémité du dispositif d'annulation d'intermodulation est mise à la terre.

2. Dispositif selon la revendication 1, **caractérisé en ce que** le dispositif d'annulation d'intermodulation (5) est disposé au niveau d'un port d'antenne (2) du dispositif passif, et un coupleur de puissance (6) est configuré pour coupler le signal transmis au niveau du port d'antenne du dispositif passif.

3. Dispositif selon la revendication 2, **caractérisé en ce qu'**une pluralité de dispositifs d'annulation d'intermodulation (5) est disposée au niveau du port d'antenne (2) du dispositif passif pour obtenir un effet de superposition sur le signal d'intermodulation du signal transmis.

4. Dispositif selon la revendication 1, **caractérisé en ce que** le coupleur de puissance (6) est configuré pour coupler le signal de puissance dans une bande de fréquence de transmission du dispositif passif.

5. Dispositif selon la revendication 1, **caractérisé en ce qu'**une quantité de couplage du coupleur de puissance est comprise entre 16 et 60 dB.

6. Dispositif selon la revendication 1, **caractérisé en ce que** le dispositif non linéaire est configuré de sorte que si une puissance d'entrée est comprise entre 0,01 et 100 mW sans courant continu polarisé, le signal d'intermodulation produit par le dispositif non linéaire est supérieur à un signal devant être annulé d'une valeur comprise entre 0,01 et 100 pW.

7. Duplexeur comprenant un dispositif d'annulation d'intermodulation, un port de transmission (3), un port de réception (4), et un port d'antenne (2) ; le dispositif d'annulation d'intermodulation (5) est disposé au niveau du port d'antenne (2), **caractérisé en ce que** le dispositif d'annulation d'intermodulation (5) comprend les caractéristiques de l'une quelconque des revendications 1-6.

8. Duplexeur selon la revendication 7, **caractérisé en ce que** le dispositif d'annulation d'intermodulation (5) est disposé au niveau du port d'antenne (2) du duplexeur, et le coupleur de puissance (6) est configuré pour coupler le signal transmis/reçu au niveau du port d'antenne du duplexeur.

9. Duplexeur selon la revendication 7, **caractérisé en ce qu'**une pluralité de dispositifs d'annulation d'intermodulation (5) est disposée au niveau du port d'antenne (2) du duplexeur pour obtenir l'effet de superposition sur le signal d'intermodulation du signal transmis.

10. Duplexeur selon la revendication 7, **caractérisé en ce que** le coupleur de puissance (6) est configuré pour coupler le signal de puissance dans la bande de fréquence de transmission du duplexeur.

11. Duplexeur selon la revendication 7, **caractérisé en ce qu'**une quantité de couplage du coupleur de puissance est comprise entre 16 et 60 dB.

12. Duplexeur selon la revendication 7, **caractérisé en ce que** le dispositif non linéaire est configuré de sorte que si la puissance d'entrée est comprise entre 0,01 et 100 mW sans le courant continu de polarisation, le signal d'intermodulation produit par le dispositif non linéaire est supérieur au signal devant être annulé d'une valeur comprise entre 0,01 et 100 pW.

13. Procédé d'annulation d'un signal d'intermodulation d'un dispositif passif, le procédé comprenant les étapes suivantes :
1) le couplage d'une partie d'un signal transmis (10, 11) comprenant un signal de puissance (10) et un signal d'intermodulation (11) à partir du dispositif passif à travers une entrée/sortie d'un dispositif d'annulation d'intermodulation (5) qui est configuré comme un port d'entrée et de sortie commun, dans lequel un niveau d'un signal transmis couplé (12) est inférieur au niveau du signal transmis (10, 11), dans lequel le dispositif d'annulation d'intermodulation (5) comprend un coupleur de puissance (6), un module de régulation (7, 8) et un dispositif non linéaire (9) ayant une extrémité mise à la terre ;
2) la réalisation d'un premier traitement du signal transmis couplé (12) par le module de régulation (7, 8) pour permettre au signal transmis couplé de produire un premier signal de puissance (13) et le traitement du premier signal de puissance (13) par le dispositif non linéaire pour produire un premier signal d'annulation d'intermodulation (14) et le premier signal de puissance (13) ;
3) la réflexion du premier signal de puissance (13) et du premier signal d'annulation d'intermodulation (14) au niveau de l'extrémité mise à la terre du dispositif non linéaire (9) et le passage des signaux réfléchis à travers le dispositif non linéaire et le module de régulation, la réalisation d'un second traitement des signaux réfléchis par le module de régulation (7, 8) pour produire un deuxième signal de puissance (15) converti à partir du premier signal de puissance (13) et un second signal d'annulation d'intermodulation (16) converti à partir du premier signal d'annulation d'intermodulation (14), dans lequel le second signal d'annulation d'intermodulation (16) et le signal d'intermodulation (11) du signal transmis dans le dispositif passif ont une même fréquence et un même niveau et des phases opposées ;
4) le passage du deuxième signal de puissance (15) et du second signal d'annulation d'intermodulation (16) à travers le coupleur de puissance (6) par le dispositif d'annulation d'intermodulation (5) et la superposition du deuxième signal de puissance (15) et du second signal d'annulation d'intermodulation (16) sur le signal d'intermodulation (11) et le signal de puissance (10) du signal transmis (10, 11) et la délivrance d'un signal superposé (17) à partir du dispositif d'annulation d'intermodulation (5) vers le dispositif passif.

14. Procédé selon la revendication 13, **caractérisé en ce que** le dispositif d'annulation d'intermodulation (5) est configuré pour coupler le signal transmis/reçu dans une bande de fréquence de transmission du dispositif passif.

15. Procédé selon la revendication 13, **caractérisé en ce qu'**une quantité de couplage du signal transmis/reçu couplé par le coupleur de puissance (6) est comprise entre 16 et 60 dB.

16. Procédé selon la revendication 13, **caractérisé en ce que** le module de régulation (7, 8) comprend un régulateur de phases (7) et un atténuateur de puissance (8) ; le régulateur de phases (7) est configuré pour réguler des phases du signal transmis couplé et du premier signal d'annulation d'intermodulation produit par le dispositif non linéaire (9) ; et l'atténuateur de puissance (8) est configuré pour réguler des niveaux du signal transmis couplé et du premier signal d'annulation d'intermodulation produit par le dispositif non linéaire (9).
